(19) Europäisches Patentamt
European Patent Office
Office européen des brevets

(11) EP 4 583 359 A1

(12) EUROPEAN PATENT APPLICATION

(43) Date of publication:
09.07.2025 Bulletin 2025/28

(21) Application number: 24215488.8

(22) Date of filing: 26.11.2024

(51) International Patent Classification (IPC):
H02J 7/00 (2006.01)

(52) Cooperative Patent Classification (CPC):
H02J 7/00047; H01M 10/425; H01M 10/482;
H02J 7/00038; H02J 7/00045; G01R 31/396;
H01M 10/4221

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 04.01.2024 KR 20240001738

(71) Applicant: SAMSUNG SDI CO., LTD.
Yongin-si, Gyeonggi-do 17084 (KR)

(72) Inventors:
• Jeon, Hyuncheol
Yongin-si, Gyeonggi-do 17084 (KR)
• Kim, Hyun
Yongin-si, Gyeonggi-do 17084 (KR)

(74) Representative: Gulde & Partner
Patent- und Rechtsanwaltskanzlei mbB
Berliner Freiheit 2
10785 Berlin (DE)

(54) METHOD AND APPARATUS FOR SETTING BATTERY PACK IDENTIFIER

(57) A method and apparatus for setting a battery pack identifier may be provided. The apparatus for setting a battery pack identifier of a battery pack may include, a first supply configured to supply a power source voltage through a first pin; a second supply configured to supply a ground voltage through a second pin; a plurality of analog-to-digital converters configured to have an input pin and an output pin, and configured to transmit a voltage corresponding to a voltage input through the input pin to the output pin; a plurality of jumper wiring configured to connect input pins of the plurality of analog-to-digital converters with the first pin or the second pin, respectively; and a controller configured to set the battery pack identifier of the battery pack based on the voltages received through the output pin of each of the plurality of analog-to-digital converters.

FIG. 4

EP 4 583 359 A1

**Description**

**BACKGROUND**

**(a) Field**

This disclosure relates to a method and apparatus for setting a battery pack identifier.

**(b) Description of the Related Art**

Electric vehicles (EVs) mainly use battery device as a power source to drive motors. As battery device with high output and large charging capacity is desired, battery device in which a plurality of battery packs is connected in parallel are being used.

In this way, as the plurality of battery packs are used, identification of the plurality of battery packs is desired.

In one method, different hardware may be provided to the plurality of battery packs for identification of the plurality of battery packs. However, in case of this method, costs may be increased by producing different versions of hardware.

Another method is to allocate an identifier to each battery pack in software. However, in case of this method, software development complexity may be increased.

**SUMMARY**

The present invention is set out in the appended set of claims, wherein the drawings and respective description relate to advantageous embodiments thereof.

The present invention provides a method and apparatus for setting a battery pack identifier that sets the identifier of each of a plurality of battery packs using the same hardware. Thus, it is possible to set a battery pack identifier without providing different hardware for each battery pack to set the battery pack identifier. In addition, software processing for setting the battery pack identifier may not be necessary.

According to a first aspect of the present invention, an apparatus for setting a battery pack identifier of a battery pack is provided. The apparatus for setting a battery pack identifier of a battery pack includes, a first supply configured to supply a power source voltage through a first pin; a second supply configured to supply a ground voltage through a second pin; a plurality of analog-to-digital converters configured to have an input pin and an output pin, and configured to transmit a voltage corresponding to a voltage input through the input pin to the output pin; a plurality of jumper wiring configured to connect input pins of the plurality of analog-to-digital converters with the first pin or the second pin, respectively; and a controller configured to set the battery pack identifier of the battery pack based on the voltages received through the output pin of each of the plurality of analog-to-digital converters.

The apparatus according to the first aspect may further comprise: a pull-up voltage supply comprising the first pin and a resistor R1.

The input pin may be connected to the first pin or the second pin through the jumper wiring.

Each of the plurality of analog-to-digital converters may include, a voltage divider circuit comprising a plurality of first resistors connected between the input pin and a ground, and configured to provide a voltage divided by the plurality of first resistors to the output pin.

The voltage divider circuit may further include, a second resistor connected between a power source supplying the power source voltage and the input pin.

The controller may be configured to detect disconnection of the plurality of jumper wiring based on the voltages received through the output pin of the plurality of analog-to-digital converters. Thus, it is possible to detect defects such as non-connection or disconnection of the jumper wiring through the voltage received through the output pin 2422 of the analog-to-digital converters.

The controller may be configured to determine the value of each bit of the battery pack identifier based on the voltage received through the output pin of each of the plurality of analog-to-digital converters.

If the voltage received through the output pin is the ground voltage, the controller may be configured to set the value of a corresponding bit to a first value, and if the voltage received through the output pin is greater than the ground voltage, may be configured to set the value of the corresponding bit to a second value different from the first value

According to another aspect of the present invention, a method for setting an identifier of a battery pack in an apparatus for setting a battery pack identifier is provided. The method for setting an identifier of a battery pack includes, converting, by each of a plurality of analog-to-digital converters, a voltage input through an input pin into a first voltage; and setting an identifier of the battery pack based on the first voltage converted by each of the plurality of analog-to-digital converters.

A power source voltage or a ground voltage may be supplied to each input pin of the plurality of analog-to-digital converters according to external control.

The input pins of the plurality of analog-to-digital converters may be connected to a first pin supplying the power source voltage or a second pin supplying the ground voltage through a plurality of jumper wiring, respectively.

The converting may include dividing the input voltage by a plurality of first resistors connected between the input pin and a ground.

The setting an identifier of the battery pack may include determining the value of each bit of the identifier based on the first voltage converted by each of the plurality of analog-to-digital converters.

The determining the value of each bit of the identifier may include, if the first voltage is the ground voltage, setting the value of a corresponding bit to a first value; and if the first voltage is greater than the ground voltage, setting the value of a corresponding bit to a second value different from the first value.

A third aspect of the present invention is a battery pack comprising at least one battery module, a battery management system, BMS, a switch, and

the apparatus according to the first aspect.

## BRIEF DESCRIPTION OF THE DRAWINGS

FIG. 1 is a diagram showing an example of a battery system according to an embodiment.

FIG. 2 is a diagram illustrating an example of the battery pack shown in FIG. 1.

FIG. 3 is a diagram showing an apparatus for setting a battery pack identifier according to an embodiment.

FIG. 4 is a circuit diagram of the pull-up voltage supply, ADC, and ground voltage supply shown in FIG. 3.

FIG. 5 to 8 are diagrams illustrating an example of a method for determining a battery pack identifier in an apparatus for setting a battery pack identifier.

## DETAILED DESCRIPTION OF THE EMBODIMENTS

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art. The drawings and description are to be regarded as illustrative in nature and not restrictive. Like reference numerals designate like elements throughout the specification. In the flowchart described with reference to the drawings in this specification, the order of operations may be changed, several operations may be merged, some operations may be divided, and specific operations may not be performed.

Throughout the specification and claims, if a part is referred to "include" a certain element, it may mean that it may further include other elements rather than exclude other elements, unless specifically indicated otherwise.

In addition, expressions described in the singular may be interpreted in the singular or plural unless explicit expressions such as "one" or "single" are used.

Furthermore, terms including an ordinal number, such as first, second, etc., may be used to describe various elements, but the elements are not limited by the terms. The above terms are used only for the purpose of distinguishing one element from another element. For example, without departing from the scope of the present disclosure, a first element may be referred to as a second element, and similarly, a second element may be referred to as a first element.

In addition, if a component is referred to be "connected" with another component, it includes not only the case where two components are "directly connected" but also the case where two components are "indirectly or non-contactedly connected" with another component interposed therebetween, or the case where two components are "electrically connected." On the other hand, if an element is referred to as "directly connected" to another element, it should be understood that no other element exists in the middle.

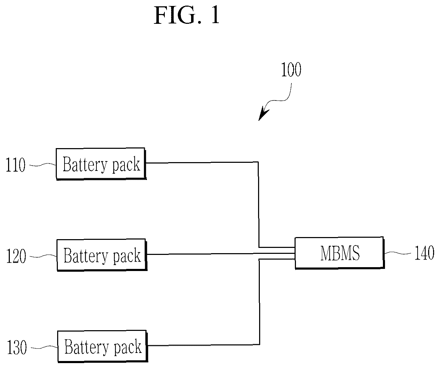

FIG. 1 is a diagram showing an example of a battery system according to an embodiment.

Referring to FIG. 1, the battery system 100 may include a plurality of battery packs 110, 120, and 130, and a master battery management system (MBMS) 140. Although three battery packs 110, 120, and 130 are shown in FIG. 1 for convenience, the number of battery packs 110, 120, and 130 is not limited thereto.

The plurality of battery packs 110, 120, and 130 may be connected to the MBMS 140. The plurality of battery packs 110, 120, and 130 may be connected to the MBMS 140 through wiring.

Each of the plurality of battery packs 110, 120, and 130 may set a battery pack identifier based on a control signal input from the outside and provide the set battery pack identifier to the MBMS 140.

The MBMS 140 may control the battery packs 110, 120, and 130 using the battery pack identifiers of the battery packs 110, 120, and 130. As one example, the MBMS 140 may control charging or discharging of the battery packs 110, 120, and 130 using the battery pack identifiers of the battery packs 110, 120, and 130.

In some embodiments, the battery system 100 may have a structure that may be connected to an external device. If the external device is a load, the battery system 100 may be discharged by operating as a power source that supplies power to the load. The external device that operates as the load may be, for example, an electronic device, a transportation device, or an energy storage system (ESS), and the transportation device may be a vehicle such as an electric vehicle or a hybrid vehicle.

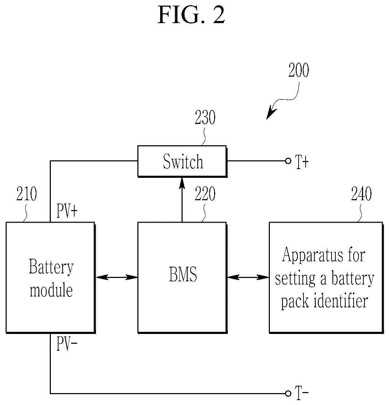

FIG. 2 is a diagram illustrating an example of the battery pack shown in FIG. 1.

Referring to FIG. 2, the battery pack 200 includes at least one battery module 210, a BMS 220, a switch 230, and an apparatus for setting a battery pack identifier 240. In FIG. 2, the battery pack 200 may be the battery pack 110, 120, or 130 shown in FIG. 1.

The battery pack 200 may be connected to an external device through terminals T+ and T-. If the external device is a charging device, the battery pack 200 may be charged by the charging device. If the external device is a load, the battery pack 200 may be discharged by the load.

The at least one battery module 210 may include a plurality of cells electrically connected to each other in series and/or parallel. The battery module 210 may include a positive terminal PV+ and a negative terminal PV-.

The switch 230 may be connected between the positive terminal PV+ of the battery module 210 and the terminal T+ of the battery pack 200, and may control the current path during charging and discharging of the battery module 210. Closing and opening of the switch 230 may be controlled according to a switch control signal supplied from the BMS 220.

The BMS 220 may control and manage the overall operation of the battery pack 200. The BMS 220 may collect the overall status information of the battery module 210 and the cells included in the battery module 210, and monitor the overall status of the battery module 210 and the cells included in the battery module 210. In some embodiments, BMS 220 may measure or collect cell data sensed by each cell. For example, cell data may include voltage data of a cell. In some embodiments, BMS 220 may collect data sensed by battery module 210. For example, such data may include data regarding the current or temperature of the battery module 210.

The BMS 220 may perform various control functions to adjust the state of the battery module 210 and the cells included in the battery module 210 based on the status information of the battery module 210 and the cells included in the battery module 210. As an example, the BMS 220 may control the charging and discharging current of the battery module 210 based on information such as a plurality of cell voltages and battery currents, and perform a cell balancing operation for a plurality of cells.

The BMS 220 may transmit the collected data to the MBMS (140 in FIG. 1).

The MBMS (140 in FIG. 1) can store and manage data collected from the BMS 220 of the battery pack 200 and control the battery pack 200 based on the collected data.

The MBMS (140 in FIG. 1) may collect data from a plurality of battery packs 110, 120, and 130 as shown in FIG. 1, and may control the plurality of battery packs 110, 120, and 130 based on the collected data. Therefore, a battery pack identifier is desired to distinguish each battery pack 110, 120, and 130.

According to an embodiment, the battery pack identifier of the battery pack 200 may be set by the apparatus for setting a battery pack identifier 240 within the battery pack 200.

The apparatus for setting a battery pack identifier 240 may set the battery pack identifier according to external control. The apparatus for setting a battery pack identifier 240 may transmit the battery pack identifier to the BMS 220.

The BMS 220 may transmit the collected data along with the battery pack identifier to the MBMS (140 in FIG. 1).

The MBMS (140 in FIG. 1) may store and manage received data in response to the battery pack identifier and control the battery pack 200 using the battery pack identifier.

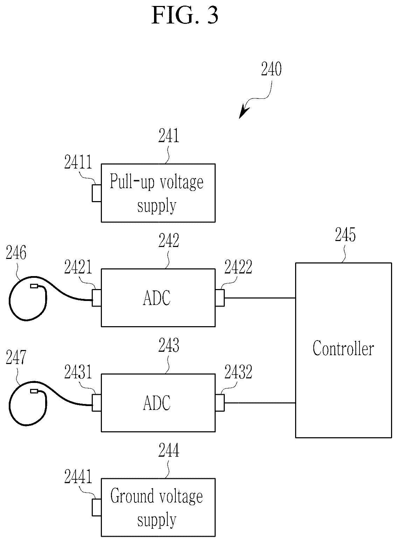

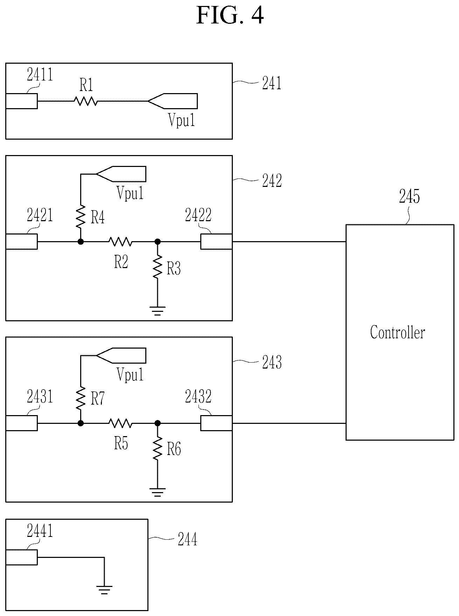

FIG. 3 is a diagram showing an apparatus for setting a battery pack identifier according to an embodiment, and FIG. 4 is a circuit diagram of the pull-up voltage supply, ADC, and ground voltage supply shown in FIG. 3.

Referring to FIG. 3, the apparatus for setting a battery pack identifier 240 may include a pull-up voltage supply 241, a plurality of analog to digital converters (ADCs) 242 and 243, a ground voltage supply 244, and a controller 245. In additionally, the apparatus for setting a battery pack identifier 240 may further include jumper wirings 246 and 247.

Referring to FIG. 4, the pull-up voltage supply 241 may supply a pull-up voltage Vpu1 from a pull-up power source. The pull-up power source may refer to a power source that supplies a power supply voltage. The pull-up voltage supply 241 may include a pull-up power source pin 2411 and a resistor R1. The resistor R1 may be connected between the pull-up power source and the pull-up power source pin 2411, and the pull-up power source pin 2411 may supply the pull-up voltage Vpu1 to the outside.

The ground voltage supply 244 may supply a ground voltage. The ground voltage supply 244 may include a ground pin 2441 for outputting the ground voltage to the outside. The ground pin 2441 may be connected to a ground.

The ADC 242 may include an input pin 2421, an output pin 2422, and resistors R2, R3, and R4. The resistor R2 may be connected between the input pin 2421 and the output pin 2422. The output pin 2422 may be connected to the controller 245 through wiring. The resistor R3 may be connected between the output pin 2422 and the ground. The resistor R4 may be connected between the input pin 2421 and the pull-up power source that supplies the pull-up voltage Vpu1. The resistors R2, R3, and R4 may divide a voltage of the input pin 2421 and provide the divided voltage to the output pin 2422.

That is, the resistors R2, R3, and R4 may be a voltage divider circuit.

According to an embodiment, the input pin 2421 may be connected to the pull-up power source pin 2411 or the ground pin 2441 through the jumper wiring 246. If the input pin 2421 is connected to the pull-up power source pin 2411, the pull-up voltage Vpu1 may be supplied to the input pin 2421 through the pull-up voltage supply 241. The pull-up voltage Vpu1 supplied from the pull-up voltage supply 241 may be divided by the resistors R1, R2, R3, and R4, and the divided voltage may be transmitted to the output pin 2422. At this time, the divided voltage may be a voltage greater than 0V. If the input pin 2421 is connected to the ground pin 2441, the voltage of the input pin 2421 may be 0V, and 0V may be transmitted to the output pin 2422.

The ADC 243 may include an input pin 2431, an output pin 2432, and resistors R5, R6, and R7. The resistance values of the resistors R5, R6, and R7 may be the same as the resistance values of the resistors R2, R3, and R4, respectively. The resistor R5 may be connected between the input pin 2431 and the output pin 2432. The output pin 2432 may be connected to the controller 245 through wiring. The resistor R6 may be connected between the output pin 2432 and the ground. The resistor R7 may be connected between the input pin 2431 and a pull-up power source that supplies the pull-up voltage Vpu1. The resistors R5, R6, and R7 may divide the voltage of the input pin 2431 and provide the divided voltage to the output pin 2432. The resistors R5, R6, and R7 may be a voltage divider circuit.

In some embodiments, the resistance values of the resistors R5, R6, and R7 may be different from the resistance values of the resistors R2, R3, and R4, respectively. In this case, the voltage output through the output pin 2422 and the voltage output through the output pin 2432 will be different.

According to an embodiment, the input pin 2431 may be connected to the pull-up power source pin 2411 or the ground pin 2441 through a jumper wiring 247.

If the input pin 2431 is connected to the pull-up power source pin 2411, the voltage of the input pin 2431 may be the pull-up voltage Vpu1, the pull-up voltage Vpu1 may be divided by the resistors R1, R7, R5 and R6, and the divided voltage may be transmitted to the output pin 2432. At this time, the divided voltage may be a voltage greater than 0V.

If the input pin 2431 is connected to the ground pin 2441, the voltage of the input pin 2431 may be 0V, and 0V may be transmitted to the output pin 2432.

The controller 245 may set the battery pack identifier of the battery pack 200 based on information transmitted through the output pins 2422 and 2432 of the ADCs 242 and 243.

In some embodiments, the controller 245 may detect disconnection of the jumper wirings 246 and 247 to input pins 2421 and 2431 of ADCs 242, based on information transmitted through the output pins 2422 and 2432 of the ADCs 242 and 243. That is, the controller 245 may detect whether the jumper wirings 246 and 247 are not connected to the input pins 2421 and 2431. The disconnection of the jumper wirings 246 and 247 may mean that no voltage is input to the input pins 2421 and 2431 of the ADCs 242 and 243. For example, if the jumper wiring 246 is not connected to the input pin 2421 of the ADC 242, no voltage may be input to the input pin 2421 of the ADC 242. In this case, the pull-up voltage Vpu1 supplied inside the ADC 242 may be divided by the resistors R2, R3, and R4. Meanwhile, if the pull-up voltage Vpu1 is input through the connection of the jumper wiring 246 to the input pin 2421 of the ADC 242, the pull-up voltage Vpu1 may be divided by the resistors R1, R4, R2, and R3. The voltage divided by the resistors R1, R4, R2, and R3 is different from the voltage divided by the resistors R2, R3, and R4.

For example, if the input pin 2421 of the ADC 242 and the pull-up power source pin 2411 are connected through the jumper wiring 246, the voltage VOUT1 output through the output pin 2422 may be expressed as equation 1.

(Equation 1)

$$VOUT1 = Vpu1 \times \frac{R3}{(R1//R4) + R2 + R3}$$

In Equation 1, (R1//R4) may represent the total resistance value of the resistor R1 and resistor R4 connected in parallel.

If the input pin 2421 of the ADC 242 and the pull-up power source pin 2411 are not connected through the jumper wiring 246, the voltage VOUT2 output through the output pin 2422 may be expressed as Equation 2.

(Equation 2)

$$VOUT2 = Vpu1 \times \frac{R3}{R4 + R2 + R3}$$

Accordingly, the controller 245 may detect defects such as non-connection or disconnection of the jumper wiring 246 through the voltage received through the output pin 2422 of the ADC 242.

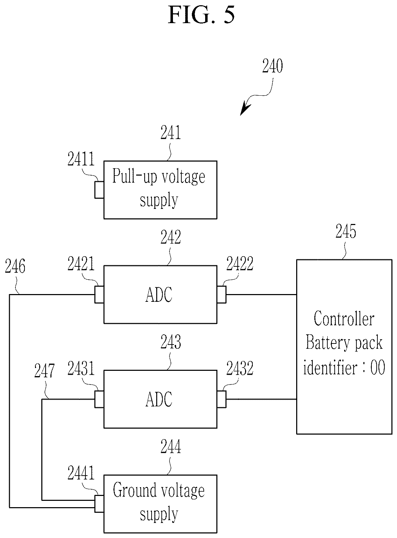

Next, an example of a method for determining a battery pack identifier in an apparatus for setting a battery pack identifier will be described with reference to FIGS. 5 to 8.

FIG. 5 to 8 are diagrams illustrating an example of a method for determining a battery pack identifier in an apparatus for setting a battery pack identifier.

Referring to FIG. 5, the input pin 2421 of the ADC 242 may be connected to the ground pin 2441 through the jumper wiring 246, and the input pin 2431 of the ADC 243 may be connected to the ground pin 2441 through the jumper wiring 247. As a result, the controller 245 may receive 0V from output pin 2422 of ADC 242, and may receive 0V from output pin 2432 of ADC 243, and may determine the battery pack identifier of battery pack 200 as "00".

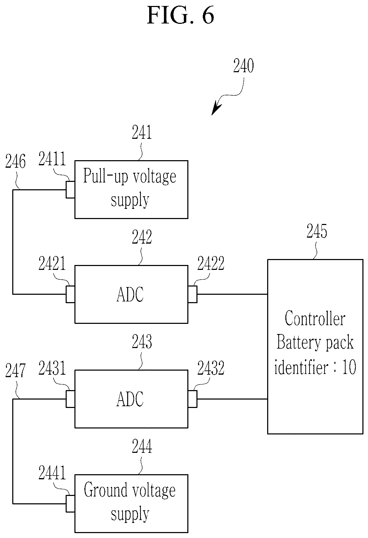

Referring to FIG. 6, the input pin 2421 of the ADC 242 may be connected to the pull-up power source pin 2411 through the jumper wiring 246, and the input pin 2431 of the ADC 243 may be connected to the ground pin 2441 through the jumper wiring 247. As a result, the controller 245 may receive V1 voltage from output pin 2422 of ADC 242, may receive 0V from output pin 2432 of ADC 243, and may determine the battery pack identifier of battery pack 200 as "10". Here, V1 voltage may represent the divided voltage of the resistors R1, R4, R2, and R3 with respect to the pull-up voltage Vpu1.

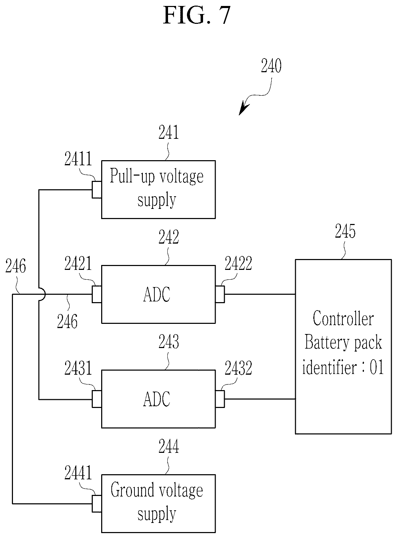

Referring to FIG. 7, the input pin 2421 of the ADC 242 may be connected to the ground pin 2441 through the jumper wiring 246, and the input pin 2431 of the ADC 243 may be connected to the pull-up power source pin 2441 through the jumper wiring 247. As a result, controller 245 may receive 0V from output pin 2422 of ADC 242, may receive V1 voltage from output pin 2432 of ADC 243, and may determine the battery pack identifier of battery pack 200 as "01".

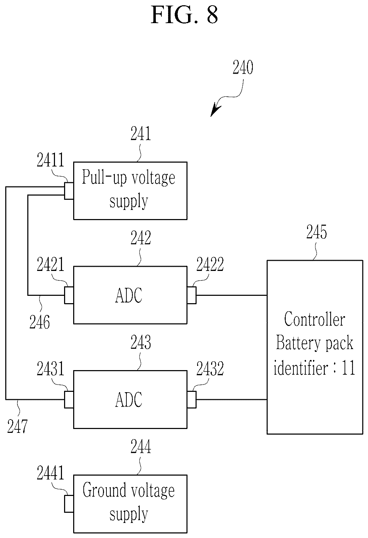

Referring to FIG. 8, the input pin 2421 of the ADC 242 may be connected to the pull-up power source pin 2411 through the jumper wiring 246, and the input pin 2431 of the ADC 243 may be connected to the pull-up power source pin 2411 through the jumper wiring 247. As a result, controller 245 may receive V1 voltage from output pin 2422 of ADC 242, may receive V1 voltage from output pin 2432 of ADC 243, and may determine the battery pack identifier of battery pack 200 as "11".

In some embodiments, the controller 245 may determine the battery pack identifier by allocating a bit value of 1 in response to the V1 voltage and a bit value of 0 in response to 0V, as shown in FIGS. 5 to 8.

Alternatively, in some embodiments, the controller 245 may determine the battery pack identifier by allocating a bit value of 0 in response to V1 voltage and a bit value of 1 in response to 0V. For example, if the controller 245 receives V1 voltage from the output pin 2422 of ADC 242 and receives 0V from the output pin 2432 of ADC 243, the battery pack identifier of this battery pack 200 may be determined as "01".

In this way, the input pins of the ADCs 242 and 243 may be selectively connected to the pull-up power source pin 2411 or the ground pin 2441 using the jumper wirings 246 and 247, so that the battery pack identifier of the battery pack 200 may be set by the apparatus for setting a battery pack identifier 240 according to the embodiment. Accordingly, the apparatus for setting a battery pack identifier 240 does not desired to provide different hardware for each battery pack to set the battery pack identifier, and may not desired software processing.

Meanwhile, in the above embodiment, the battery pack identifier of the battery pack 200 consists of 2 bits. That is, pack identifiers may be allocated to four battery packs in the battery system 100. As the number of battery packs in the battery system 100 increases, it may be possible to allocate battery pack identifiers to the battery packs by increasing the number of ADCs.

Additionally, in some embodiments, the apparatus for setting a battery pack identifier 240 may include a plurality of ADCs. At this time, some of the plurality of ADCs may be used to allocate battery pack identifiers, and the remaining ADCs may be used in connection with at least one sensor. Here, the sensor may be, for example, a temperature sensor or a current sensor.

According to at least one of the embodiments, it is possible to set a battery pack identifier without providing different hardware for each battery pack to set the battery pack identifier.

In addition, according to at least one of the embodiments, software processing for setting the battery pack identifier may not be necessary.

<Description of symbols>

100: Battery system
110, 120, 130, 200: Battery pack
140: MBMS
210: Battery module
220: BMS
230: Switch

240: Apparatus for setting battery pack identifier
241: Pull-up power supply
242, 243: ADC
244: Ground voltage supply
245: Controller
246, 247: jumper wiring

**Claims**

1. An apparatus for setting a battery pack identifier (240) of a battery pack (110, 120, 130, 200), the apparatus (240) comprising:

   a first supply configured to supply a power source voltage through a first pin (2411);
   a second supply configured to supply a ground voltage through a second pin (2441);
   a plurality of analog-to-digital converters (242, 243) configured to have an input pin (2421, 2431) and an output pin (2422, 2432), and configured to transmit a voltage corresponding to a voltage input through the input pin (2421, 2431) to the output pin (2422, 2432);
   a plurality of jumper wiring (246, 247) configured to connect input pins (2421, 2431) of the plurality of analog-to-digital converters (242, 243) with the first pin (2411) or the second pin (2441), respectively; and
   a controller (245) configured to set the battery pack identifier (240) of the battery pack (110, 120, 130, 200) based on the voltages received through the output pin (2422, 2432) of each of the plurality of analog-to-digital converters (242, 243).

2. The apparatus (240) as claimed in claim 1, wherein
   the input pin (2421, 2431) is connected to the first pin (2411) or the second pin (2441) through the jumper wiring (246, 247).

3. The apparatus (240) as claimed in claim 1 or 2, wherein

   each of the plurality of analog-to-digital converters (242, 243) comprises
   a voltage divider circuit comprising a plurality of first resistors (R2, R3, R4, R5, R6, R7) connected between the input pin (2421, 2431) and a ground, and configured to provide a voltage divided by the plurality of first resistors (R2, R3, R4, R5, R6, R7) to the output pin (2422, 2432).

4. The apparatus (240) as claimed in claim 3, wherein
   the voltage divider circuit further comprises a second resistor (R4, R7) connected between a power source supplying the power source voltage and the input pin (2421, 2431).

5. The apparatus (240) as claimed in any of claims 1 to 4, wherein
   the controller (245) is configured to detect disconnection of the plurality of jumper wiring (246, 247) based on the voltages received through the output pin (2422, 2432) of the plurality of analog-to-digital converters (242, 243).

6. The apparatus (240) as claimed in any of claims 1 to 5, wherein
   the controller (245) is configured to determine the value of each bit of the battery pack identifier (240) based on the voltage received through the output pin (2422, 2432) of each of the plurality of analog-to-digital converters (242, 243).

7. The apparatus (240) as claimed in claim 6, wherein
   if the voltage received through the output pin (2422, 2432) is the ground voltage, the controller (245) is configured to set the value of a corresponding bit to a first value, and if the voltage received through the output pin (2422, 2432) is greater than the ground voltage, is configured to set the value of the corresponding bit to a second value different from the first value.

8. A method for setting an identifier of a battery pack (110, 120, 130, 200) in an apparatus for setting a battery pack identifier (240), the method comprising:

   converting, by each of a plurality of analog-to-digital converters (242, 243), a voltage input through an input pin (2421, 2431) into a first voltage; and

setting an identifier of the battery pack (110, 120, 130, 200) based on the first voltage converted by each of the plurality of analog-to-digital converters (242, 243).

9. The method as claimed in claim 8, wherein
a power source voltage or a ground voltage is supplied to each input pin (2421, 2431) of the plurality of analog-to-digital converters (242, 243) according to external control.

10. The method as claimed in claim 9, wherein
the input pins (2421, 2431) of the plurality of analog-to-digital converters (242, 243) is connected to a first pin (2441) supplying the power source voltage or a second pin (2441) supplying the ground voltage through a plurality of jumper wiring (246, 247), respectively.

11. The method as claimed in any of claims 8 to 10, wherein
the converting comprises dividing the input voltage by a plurality of first resistors (R4, R7) connected between the input pin (2421, 2431) and a ground.

12. The method as claimed in any of claims 8 to 11, wherein
the setting an identifier of the battery pack (110, 120, 130, 200) comprises determining the value of each bit of the identifier based on the first voltage converted by each of the plurality of analog-to-digital converters (242, 243).

13. The method as claimed in claim 12, wherein
the determining the value of each bit of the identifier comprises:

if the first voltage is the ground voltage, setting the value of a corresponding bit to a first value; and
if the first voltage is greater than the ground voltage, setting the value of a corresponding bit to a second value different from the first value.

14. A battery pack (200) comprising

at least one battery module (210),
a battery management system, BMS (220),
a switch (230), and
the apparatus (240) according to claim 1.

FIG. 1

# FIG. 2

# FIG. 3

240

241
2411
Pull-up voltage
supply

246
2421
242
2422
ADC

247
2431
243
2432
ADC

245
Controller

244
2441
Ground voltage
supply

# FIG. 4

# FIG. 5

240

241

2411

Pull-up voltage
supply

242

246    2421    2422

ADC

245

Controller
Battery pack
identifier : 00

243

247   2431    2432

ADC

244

2441

Ground voltage
supply

FIG. 6

# FIG. 7

240

241

2411

Pull-up voltage
supply

242

2421    246    2422

ADC

246

245

Controller
Battery pack
identifier : 01

243

2431    2432

ADC

244

2441

Ground voltage
supply

# FIG. 8

240

241

2411

Pull-up voltage
supply

242

2421    ADC    2422

246

243

2431    ADC    2432

247

244

2441    Ground voltage
supply

245

Controller
Battery pack
identifier : 11

Europäisches
Patentamt

European
Patent Office

Office européen
des brevets

# EUROPEAN SEARCH REPORT

**Application Number**

EP 24 21 5488

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CA 2 273 543 A1 (BLACK & DECKER INC [US]) 9 December 1999 (1999-12-09) | 1,8 | INV. H02J7/00 |
| Y | * page 15, line 6 - page 18, line 5; figure 6 * | 6,7,12, 13 | |
| Y | EP 2 530 807 A1 (HTC CORP [TW]) 5 December 2012 (2012-12-05) * paragraph [0007] - paragraph [0033] * | 1-14 | |
| Y | JP H05 251113 A (MATSUSHITA ELECTRIC IND CO LTD) 28 September 1993 (1993-09-28) * paragraph [0006] * | 1-14 | |
| Y | EP 2 690 748 B1 (LG CHEMICAL LTD [KR]) 12 September 2018 (2018-09-12) * paragraph [0034] - paragraph [0037] * | 6,7,12, 13 | |
| A | US 5 783 926 A (MOON BILLY GAYLE [US] ET AL) 21 July 1998 (1998-07-21) * column 1, line 65 - column 2, line 49 * | 1-14 | |

**TECHNICAL FIELDS SEARCHED (IPC)**

H02J
G01R
H01M

The present search report has been drawn up for all claims

| Place of search | Date of completion of the search | Examiner |
|---|---|---|
| Munich | 25 April 2025 | Jonda, Sven |

EPO FORM 1503 03.82 (P04C01)

## ANNEX TO THE EUROPEAN SEARCH REPORT
## ON EUROPEAN PATENT APPLICATION NO.

EP 24 21 5488

25-04-2025

| Patent document cited in search report | | Publication date | Patent family member(s) | | Publication date |
|---|---|---|---|---|---|
| CA 2273543 | A1 | 09-12-1999 | CA | 2273543 A1 | 09-12-1999 |
| | | | CN | 1238462 A | 15-12-1999 |
| | | | DE | 69933817 T2 | 30-08-2007 |
| | | | EP | 0964258 A2 | 15-12-1999 |
| | | | EP | 1637897 A2 | 22-03-2006 |
| | | | JP | 2000032677 A | 28-01-2000 |
| | | | TW | 428336 B | 01-04-2001 |
| | | | US | 5945803 A | 31-08-1999 |
| EP 2530807 | A1 | 05-12-2012 | EP | 2530807 A1 | 05-12-2012 |
| | | | US | 2012306505 A1 | 06-12-2012 |
| JP H05251113 | A | 28-09-1993 | NONE | | |
| EP 2690748 | B1 | 12-09-2018 | BR | 112013027979 A2 | 29-11-2022 |
| | | | CL | 2013003279 A1 | 16-05-2014 |
| | | | CN | 103563209 A | 05-02-2014 |
| | | | EP | 2690748 A2 | 29-01-2014 |
| | | | JP | 5972364 B2 | 17-08-2016 |
| | | | JP | 2014522629 A | 04-09-2014 |
| | | | KR | 20120134059 A | 11-12-2012 |
| | | | US | 2013249475 A1 | 26-09-2013 |
| | | | WO | 2012165858 A2 | 06-12-2012 |
| US 5783926 | A | 21-07-1998 | NONE | | |

EPO FORM P0459